(19) Europäisches Patentamt
European Patent Office
Office européen des brevets

(11) **EP 1 780 827 A1**

(12) **EUROPEAN PATENT APPLICATION**

(43) Date of publication:
**02.05.2007 Bulletin 2007/18**

(51) Int Cl.:
***H01M 14/00*** *(2006.01)* *H01L 31/04* *(2006.01)*
*H01L 31/042* *(2006.01)*

(21) Application number: **06254369.9**

(22) Date of filing: **21.08.2006**

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK YU**

(30) Priority: **21.10.2005 KR 20050099531**

(71) Applicant: **Samsung Electronics Co., Ltd.**
**Suwon-si**
**442-742 Gyeonggi-Do (KR)**

(72) Inventors:
- **Jung, Won Cheol**
  **Seongdong-gu**
  **Seoul 133-767 (KR)**
- **Nam, Jung Gyu**
  **Yongin-si**
  **Gyeonggi-do, 449-737 (KR)**
- **Park, Sang Cheol**
  **Songpa-gu**
  **Seoul 138-769 (KR)**
- **Sohn, Byung Hee**
  **Yongin-si**
  **Gyeonggi-do, 449-959 (KR)**

(74) Representative: **Kyle, Diana**
**Elkington and Fife LLP,**
**Prospect House**
**8 Pembroke Road**
**Sevenoaks,**
**Kent TN13 1XR (GB)**

# (54) Semiconductor electrode, fabrication method thereof and solar cell comprising the same

(57) A semiconductor electrode, a fabrication method thereof and a solar cell including the semiconductor electrode each include a metal oxide layer of metal oxide nanoparticles having dye molecules adsorbed thereon. In the semiconductor electrode of the present invention, the surface of the metal oxide layer is treated with an aromatic or heteroaromatic organic material having an electron-donating group. Thus, since the semiconductor electrode can provide an effect of improving photoelectric efficiency by virtue of an increase in short-circuit photocurrent density and open-circuit voltage, it can be applied to a high efficiency solar cell.

**Fig. 1**

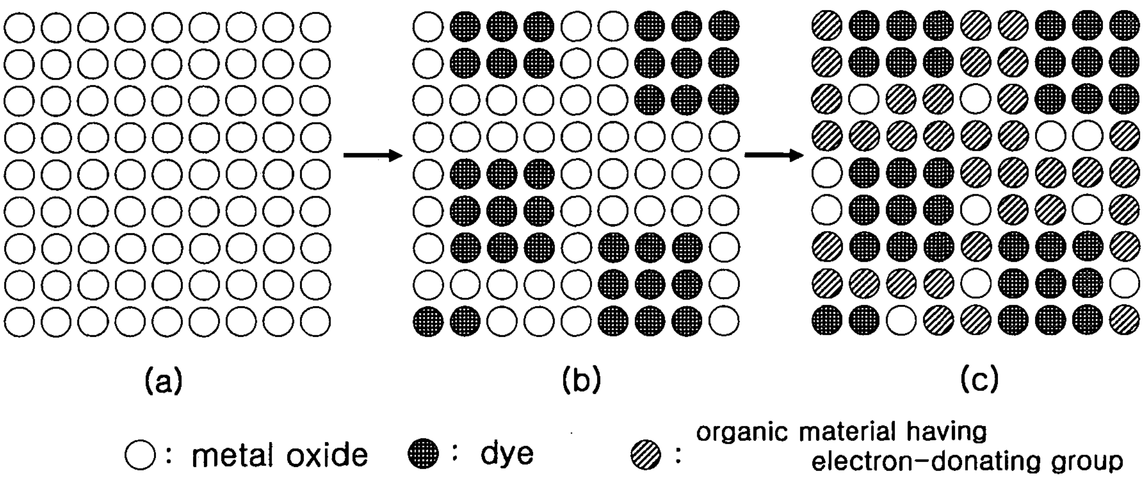


EP 1 780 827 A1

## Description

The present invention relates, generally, to a semiconductor electrode, a fabrication method thereof, and a solar cell comprising the same, and more particularly, to a semiconductor electrode, in which the surface of metal oxide having a dye adsorbed thereon is treated with an aromatic or heteroaromatic organic material having an electron-donating group, thus increasing the photoelectric efficiency of a solar cell, and to a method of fabricating such a semiconductor electrode and a solar cell comprising the semiconductor electrode.

In general, a solar cell, which is a photoelectric conversion device for converting solar light into electrical energy, is usable without limit and is environmentally friendly, unlike other energy sources. Thus, the solar cell is becoming increasingly important over time. In particular, when such solar cells are mounted to various portable information instruments, such as portable computers, mobile phones, personal portable terminals, etc., these portable information instruments can be electrically charged solely using solar light.

Primarily, a silicon solar cell made of monocrystal or polycrystal silicon has been conventionally used. However, the silicon solar cell requires the use of large and expensive equipment, and expensive materials leading to high fabrication costs. Further, the ability to improve the conversion efficiency of solar energy into electrical energy is limited. Thus, novel alternatives are desired.

As an alternative to the silicon solar cell, a solar cell capable of being inexpensively fabricated using organic material is of interest. In particular, a dye-sensitized solar cell having a very low fabrication cost is receiving attention. The dye-sensitized solar cell is a photoelectrochemical solar cell comprising a semiconductor electrode composed of metal oxide nanoparticles having dye molecules adsorbed thereon, a counter electrode, and a redox electrolyte loaded in a space between the two electrodes. The semiconductor electrode consists of a conductive transparent substrate and a light-absorbing layer including metal oxide and a dye.

When solar light is incident on the solar cell, photons are first absorbed by the dye. The dye is changed into an excited state by absorbing solar light and thus the electrons of the dye are transferred to the conduction band of metal oxide. Such electrons are transferred to the semiconductor electrode and then flow to the external circuit in order to transmit electrical energy, after which they are transferred to the counter electrode in a low energy state in which the transmitted energy is depleted.

In the dye-sensitized solar cell, since the metal oxide semiconductor film has a very large surface area, a large amount of dye may be held on the surface of the metal oxide semiconductor film, thus manifesting excellent light absorption efficiency of the cell. Further, the metal oxide particles, which are coated with a monomolecular dye, should not contact the electrolyte, as a rule. However, in practice, the surface of metal oxide layer is not completely covered with the dye, and a considerable portion of the metal oxide layer directly contacts the electrolyte.

In this way, when direct contact between the metal oxide layer and the electrolyte occurs, photoelectric efficiency is decreased. Thus, electromotive force is lowered, attributable to back electron transfer, in which electrons in an excited state are converted into electrons in a ground state through recombination of the electrons transferred to the conduction band of metal oxide with the redox couple in the electrolyte or with the dye molecules. Hence, thorough attempts to increase the photoelectric efficiency of the solar cell have been made by minimizing the direct contact area between the metal oxide and electrolyte as much as possible such that back electron transfer is prevented, thus increasing the electrical conductivity of the electrode.

As a conventional technique for solving such a problem, Japanese Patent Laid-open Publication No. 2004-171969 discloses a method of using, as a semiconductor electrode, a porous titanium oxide thin film electrode comprising long-chain alkyl carboxylic acid having at least 10 carbons and a photosensitive dye adsorbed together. However, according to the above method, less of an interaction between the dye molecules results not in prevention of back electron transfer in the semiconductor electrode, but merely in exhibition of the inherent function of the dye as a photosensitizer. Thus, an effect of improving the photoelectric efficiency is limited.

Accordingly, the present invention has been made keeping in mind the above problems occurring in the related art, and exemplary embodiments of the present invention provide a semiconductor electrode, in which back transfer of electrons in an excited state is prevented, thus increasing photoelectric efficiency.

Other exemplary embodiments of the present invention provide a method of fabricating such a semiconductor electrode.

Further exemplary embodiments of the present invention provide a solar cell having high efficiency, and which includes the exemplary embodiment of a semiconductor electrode.

In an exemplary embodiment of a semiconductor electrode, the semiconductor electrode includes a metal oxide layer of metal oxide nanoparticles having dye molecules adsorbed thereon, in which the surface of the metal oxide layer is treated with an aromatic or heteroaromatic organic material having an electron-donating group.

In the semiconductor electrode, the aromatic or heteroaromatic organic material may be a compound having at least one aromatic or heteroaromatic ring and at least one functional group forming primary or secondary bonding with metal oxide.

Specifically, the organic material having an electron-donating group may have the structure represented by Formula 1 or Formula 2 below:

Formula 1

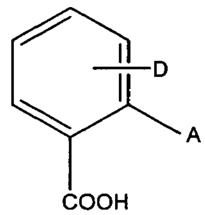

wherein A is H, COOH, OH, OR, or SH, and D is H, OH, R, OR, SH, NRR', or halogen elements, in which R and R' are each a $C_1$~$C_{10}$ alkyl group;

Formula 2

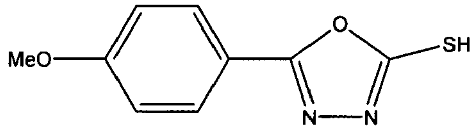

In the semiconductor electrode of the present invention, the metal oxide may be titanium oxide, niobium oxide, hafnium oxide, indium oxide, tin oxide or zinc oxide.
In another exemplary embodiment, a method of fabricating a semiconductor electrode includes forming a metal oxide layer having a dye adsorbed thereon on a transparent electrode; and treating the surface of the metal oxide layer with an aromatic or heteroaromatic organic material having an electron-donating group.
In yet another exemplary embodiment, a solar cell includes the semiconductor electrode mentioned above, an electrolyte layer and a counter electrode.
The above and other aspects, features and other advantages of the present invention will be more clearly understood from the following detailed description taken in conjunction with the accompanying drawings, in which:

FIGS. 1A to 1C are plan views showing the structure of an exemplary embodiment of a semiconductor electrode according to the present invention;
FIG. 2 is a schematic cross-sectional view showing the exemplary embodiment of the semiconductor electrode according to the present invention;
FIG. 3 is a schematic cross-sectional view showing an exemplary embodiment of a dye-sensitized solar cell according to the present invention; and
FIG. 4 is a graph showing the FTIR (Fourier Transform InfraRed) spectrum of the exemplary embodiment of the semiconductor electrode fabricated in the example according to the present invention.

The invention will now be described more fully hereinafter with reference to the accompanying drawings, in which embodiments of the invention are shown. This invention may, however, be embodied in many different forms and should not be construed as limited to the embodiments set forth herein. Rather, these embodiments are provided so that this disclosure will be thorough and complete, and will fully convey the scope of the invention to those skilled in the art. Like reference numerals refer to like elements throughout.
It will be understood that when an element is referred to as being "on" another element, it can be directly on the other element or intervening elements may be present therebetween. In contrast, when an element is referred to as being "directly on" another element, there are no intervening elements present. As used herein, the term "and/or" includes any and all combinations of one or more of the associated listed items.
It will be understood that, although the terms first, second, third etc. may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, a first element, component, region, layer

or section discussed below could be termed a second element, component, region, layer or section without departing from the teachings of the present invention.

The terminology used herein is for the purpose of describing particular embodiments only and is not intended to be limiting of the invention. As used herein, the singular forms "a", "an" and "the" are intended to include the plural forms as well, unless the context clearly indicates otherwise. It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

Spatially relative terms, such as "beneath", "below", "lower", "above", "upper" and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" the other elements or features. Thus, the exemplary term "below" can encompass both an orientation of above and below. The device may be otherwise oriented (rotated 90 degrees or at other orientations) and the spatially relative descriptors used herein interpreted accordingly.

Unless otherwise defined, all terms (including technical and scientific terms) used herein have the same meaning as commonly understood by one of ordinary skill in the art to which this invention belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

Hereinafter, the present invention will be described in detail with reference to the accompanying drawings.

The semiconductor electrode of the present invention is characterized in that it includes a transparent electrode formed on a substrate, a metal oxide layer formed on the transparent electrode, and a dye adsorbed on the metal oxide layer, in which the surface of the semiconductor electrode is treated with an aromatic or heteroaromatic organic material having an electron-donating group. The organic material having an electron-donating group has at least one aromatic or heteroaromatic ring and at least one functional group capable of forming primary or secondary bonding with metal oxide.

FIGS. 1A to 1C are plan views showing the structure of an exemplary embodiment of a semiconductor electrode according to the present invention. As shown in FIGS. 1A to 1C, when a dye is adsorbed on a metal oxide layer (FIGS. 1A and 1B), the dye does not cover all of the metal oxide layer but is adsorbed on a portion thereof, thus resulting in a portion of the metal oxide layer on which the dye is not adsorbed (FIG. 1B). In the semiconductor electrode of the present invention, the metal oxide layer having the dye adsorbed thereon is treated with an organic material having an electron-donating group such that most of the surface of the metal oxide layer is covered (FIG. 1C).

The aromatic group enables electrons to flow farther by virtue of additional contribution from a resonance effect, compared to an aliphatic group, which mainly exhibits an inductive effect. That is, the aromatic or heteroaromatic organic material can increase an open-circuit voltage ($V_{oc}$) using an electron donating effect. Also, in the semiconductor electrode of the present invention, when the surface of the metal oxide layer having the dye adsorbed thereon is treated with the organic material having an electron-donating group, the transfer of electrons collected in the conduction band of the metal oxide to the oxidized redox couple or dye is blocked, and thus a short-circuit photocurrent density ($I_{sc}$) increases. Consequently, the solar cell including the semiconductor electrode of the present invention has improved photoelectric efficiency.

FIG. 2 is a schematic cross-sectional view showing the exemplary embodiment of the semiconductor electrode of FIG. 1 and according to the present invention. As shown in FIG. 2, the semiconductor electrode of the present invention includes a transparent electrode 120 formed by applying a conductive material on a substrate 110, a light-absorbing layer, and a dye 150 and an organic material 170 having an electron-donating group.

In the semiconductor electrode of the present invention, the conductive material is applied on the substrate 110, thus forming the transparent electrode 120 thereon. The substrate 110 is not particularly limited so long as it is transparent, and examples thereof include a transparent inorganic substrate, such as quartz and glass, or a transparent plastic substrate, such as polyethylene terephthalate (PET), polyethylene naphthalate (PEN), polycarbonate, polystyrene, polypropylene, etc.

Examples of the conductive material applied on the substrate 110 include, but are not limited to, indium tin oxide (ITO), fluorine-doped tin oxide (FTO), $ZnO-Ga_2O_3$, $ZnO-Al_2O_3$, $SnO_2-Sb_2O_3$, etc.

In the semiconductor electrode of the present invention, the light-absorbing layer is composed of the metal oxide layer 130 and the dye 150 adsorbed on the surface of the metal oxide layer 130. Since the light-absorbing layer should absorb the maximum possible amount of solar light energy in order to realize a high efficiency, the light-absorbing layer is preferably formed having a large surface area using porous metal oxide. The large surface of the porous metal oxide adsorbs the dye thereon.

Examples of the material for the metal oxide layer 130 include, but are not limited to, titanium oxide, niobium

oxide, hafnium oxide, indium oxide, tin oxide, or zinc oxide. The above-mentioned materials may be used alone or in combination with each other. Preferable examples of metal oxide include $TiO_2$, $SnO_2$, ZnO, $WO_3$, $Nb_2O_5$, or $TiSrO_3$, anatase type $TiO_2$ being most preferable.

It is preferred that the metal oxide constituting the light-absorbing layer have a large surface area in order to absorb a much larger quantity of light with the dye adsorbed thereon and to increase the extent of adsorption of the electrolyte layer. Hence, metal oxides of the light adsorption layer preferably have nanostructures, such as nanotubes, nanowires, nanobelts or nanoparticles.

Although the diameter of metal oxide particles constituting the metal oxide layer 130 is not particularly limited, primary particles have an average diameter of between about 1 nm and about 200 nm, and preferably between about 5 nm and about 100 nm. In addition, two or more metal oxides having different particle diameters may be mixed so as to scatter incident light and increase quantum yield.

As the dye 150 usable in the present invention, any dye typically known in the solar cell field may be used without limit. In particular, a ruthenium complex is preferable. The dye may not be particularly limited so long as the dye functions as a charge separator or photosensitizer. In addition to the ruthenium complex, xanthene dyes, such as rhodamine B, rose bengal, eosin, or erythrosine; cyanine dyes, such as quinocyanine, or cryptocyanine; basic dyes, such as phenosafranine, capri blue, thiosine, or methylene blue; porphyrine compounds, such as chlorophyll, zinc porphyrin, or magnesium porphyrin; azo dyes; phthalocyanine compounds; complex compounds, such as ruthenium trisbipyridyl; anthraquinone dyes; and polycyclic quinone dyes may be used alone or in combination. The ruthenium complex is exemplified by $RuL_2(SCN)_2$, $RuL_2(H_2O)_2$, $RuL_3$, or $RuL_2$ (where L is 2,2'-bipyridyl-4,4'-dicarboxylate).

In the semiconductor electrode of the present invention, the surface of the metal oxide layer 130 having the dye 150 adsorbed thereon is treated with the aromatic or heteroaromatic organic material 170 having an electron-donating group. Such an organic material 170 has at least one aromatic or heteroaromatic ring and at least one functional group forming primary or secondary bonding with metal oxide. Preferable examples of the aromatic or heteroaromatic organic material having an electron-donating group include an organic material having the structure represented by Formula 1 or Formula 2 below:

Formula 1

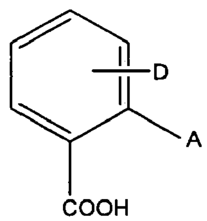

wherein A is H, COOH, OH, OR or SH, and D is H, OH, R, OR, SH, NRR' or halogen elements, in which R and R' are each a $C_1$~$C_{10}$ alkyl group;

Formula 2

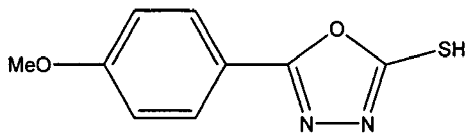

Preferable examples of the aromatic or heteroaromatic organic material 170 having an electron-donating group include, but are not limited to, benzoic acid, salicylic acid, 4-octylbenzoic acid, 4-(octyloxy)benzoic acid, 4-ethoxysalicylic acid, or 5-(4-methoxyphenyl)1,3-oxadiazole-2-thiol.

The semiconductor electrode of the present invention may be employed as semiconductor electrodes of various solar cells, and may also be applied to photoelectric color sensors, displays for operating solar cells, etc., in addition to the solar cell. The semiconductor electrode of the present invention can increase the photoelectric efficiency when applied to photoelectric conversion devices. Thus, it is possible to realize a photoelectric conversion device having high efficiency.

Further, exemplary embodiments of the present invention include a method of fabricating such a semiconductor electrode. In order to fabricate the semiconductor electrode of the present invention, a metal oxide layer 130 having a dye 150 adsorbed thereon is first formed on a transparent electrode 120. Thereafter, the surface of the metal oxide layer 130 is treated with an aromatic or heteroaromatic organic material having an electron-donating group.

Specifically, individual steps of the method of fabricating the semiconductor electrode of the present invention are described below.

(a) Formation of Metal Oxide Layer

A conductive material is applied on a predetermined substrate 110, thus preparing a transparent electrode 120, after which a light-absorbing layer of metal oxide is formed on one surface of the transparent electrode 120.

Although the process of forming the metal oxide layer 130 is not particularly limited, a wet process using metal oxide is preferably adopted, in consideration of properties, convenience, preparation cost, etc. In this regard, metal oxide powder is uniformly dispersed in an appropriate solvent to prepare a paste, which is then applied on the substrate 110 having the transparent conductive film formed thereon. As such, the coating process preferably includes a general coating process, for example, spin coating, dipping, printing, doctor blading, or sputtering or an electrophoresis process.

In the case where the metal oxide layer 130 is formed using a general coating process, after the coating process is completed, drying and sintering processes known in the art are conducted. In such a case, the drying process and the sintering process are conducted at between about 50°C and about 100°C and at between about 400°C and about 500°C, respectively.

The diameter of the metal oxide particles is not particularly limited, but the particles have an average diameter of between about 1 nm and about 200 nm, and preferably between about 5 nm and about 100 nm. In addition, two or more metal oxides having different particle diameters may be mixed in order to scatter incident light and increase the quantum yield. In addition, the metal oxide layer 130 may be formed into double layers using two metal oxides having different particle diameters.

Subsequently, the metal oxide layer 130 is immersed in a solution containing a photosensitive dye 150 for 12 hours or more using a process typically known in the art, thus adsorbing the dye 150 on the surface of metal oxide. Examples of the solvent used in the solution containing the photosensitive dye 150 include tert-butylalcohol, acetonitrile or mixtures thereof.

(b) Treatment using Organic Material having Electron-Donating Group

After the dye used for solar cells is adsorbed onto the surface of metal oxide, the aromatic or heteroaromatic organic material 170, having an electron-donating group and containing a functional group forming primary or secondary bonding with metal oxide, is dispersed in an appropriate solvent, thus preparing a dispersion of the organic material 170.

Examples of the solvent usable in the present invention include, but are not limited to, pentane, hexane, benzene, toluene, xylene, dichloromethane or chloroform. As such, it is noted that a solvent suitable for a corresponding organic material 170 should be appropriately chosen in view of the effect of the solvent on the photoelectric efficiency of the resulting solar cell.

Also, when dispersing the organic material 170 in the solvent, the organic material 170 may be ultrasonicated or heated in order to increase the dispersibility.

The metal oxide substrate having the dye 170 adsorbed thereon may be immersed in the dispersion of the organic material 170 having the electron-donating group for a sufficient period of time, or the dispersion of the organic material 170 may be sprayed onto the substrate having the light-absorbing layer formed thereon.

Finally, the semiconductor electrode having the organic material 170 is washed with the solvent used when dispersing the organic material 170 such that the organic material 170 is formed into a monolayer. This is because the formation of the organic material 170 into a thick multilayer results in a reduced probability of the electrolyte infiltrating into the dye 150. As such, examples of a suitable solvent include acetonitrile, ethanol, THF, etc. The substrate washed with the solvent is dried, thereby obtaining the semiconductor electrode of the present invention.

Further, exemplary embodiments of the present invention include a solar cell comprising the semiconductor electrode according to the present invention. FIG. 3 is a schematic cross-sectional view showing an exemplary embodiment of a dye-sensitized solar cell according to the present invention. The dye-sensitized solar cell having the semiconductor electrode of the present invention comprises a semiconductor electrode 100, an electrolyte layer 200 and a counter electrode 300. The semiconductor electrode 100 is composed of a transparent electrode 120 and a light-absorbing layer, which are sequentially formed on a substrate 110. The light-absorbing layer includes a metal oxide layer 130, a dye 150 adsorbed on the surface of the metal oxide layer 130 and an organic material 170 having an electron-donating group, in that order. The solar cell of the present invention is advantageous because back electron transfer is prevented in the semiconductor electrode 100 and the electrons are easily transferred to the electrode 100, thus increasing photoelectric efficiency.

In the solar cell of the present invention, the electrolyte layer 200 is formed of an electrolytic solution obtained by dissolving iodine in acetonitrile, NMP, 3-methoxypropionitrile, etc., but the present invention is not limited thereto. The electrolyte may be of any type so long as the electrolyte has a hole conducting function. In addition, a solid electrolyte, such as triphenylmethane, carbazole, or N,N'-diphenyl'-N,N'-bis(3-methylphenyl)-1,1'biphenyl-4,4'diamine (TPD), may be used, if necessary.

The counter electrode 300 is formed of a uniformly applied metal electrode. The counter electrode 300 may be formed of any conductive material, and may also be made of an insulating material having a conductive layer that faces the transparent electrode 120. As such, the counter electrode 300 must be formed of electrochemically stable material, in particular, platinum, gold, carbon or carbon nanotubes, for example. Moreover, to enhance redox catalytic effects, the surface of the counter electrode 300 that faces the transparent electrode 120 preferably has a microstructure, and therefore an increased surface area. For example, it is preferred that platinum be in a state of platinum black and that carbon be in a state of porous carbon.

The solar cell of the present invention is operated as follows. That is, the dye 150 adsorbed on the surface of the metal oxide layer 130 absorbs light that passes through the transparent electrode 120 and is then incident on the light-absorbing layer. By absorbing light by the dye 150, electrons are changed from a ground state to an excited state to form electron-hole pairs. The electrons in an excited state are injected into the conduction band of metal oxide and are then transferred to the electrode 120, thus generating electromotive force. When the electrons excited by light from the dye 150 are transferred to the conduction band of metal oxide, the positively charged dye 150 receives electrons from the hole transfer material of the electrolyte layer 200 and thus is restored to its original ground state. In particular, in the solar cell of the present invention, since the surface of the metal oxide layer 130 on which the dye 150 is not adsorbed is coated with the organic material 170 having an electron-donating group, back electron transfer caused by the contact between metal oxide and electrolyte 200 is blocked, thus increasing the photoelectric efficiency.

In the present invention, the method of fabricating the dye-sensitized solar cell having such a structure is not particularly limited, and may be of any type so long as it is typically known in the art. For instance, in the case where the solar cell is fabricated using the semiconductor electrode 100 of the present invention, it may be fabricated by disposing the semiconductor electrode 100 and the counter electrode 300 to face each other and simultaneously forming a space for encapsulating the electrolyte layer 200 using a predetermined encapsulating member, and then injecting an electrolytic solution into such a space, according to a process typically known in the art. As such, the transparent electrode 120 may adhere to the counter electrode 300 using an adhesive such as a thermoplastic polymer film (e.g., SURLYN, DuPont), epoxy resin or UV curing agent. After the thermoplastic polymer film is positioned between the two electrodes, they are sealed through heating and compression processes.

A better understanding of the present invention may be obtained in light of the following examples which are set forth to illustrate, but are not to be construed to limit the present invention.

Example 1

After fluorine-doped tin oxide (FTO) was applied on a glass substrate using a sputter, a paste of $TiO_2$ particles having a diameter of 13 nm was applied using a screen printing process and then dried at 70°C for 30 minutes. Subsequently, the dried substrate was placed into an electrical furnace, after which the temperature of the furnace was increased at a rate of 3 °C/min. in a normal atmosphere and thus the substrate was maintained at 450°C for 30 minutes and then cooled at the same rate as that applied when increasing the temperature, therefore obtaining a porous $TiO_2$ film of about 15 μm thick.

Subsequently, the glass substrate having the metal oxide layer formed thereon was immersed in an ethanol solution of 0.3 mM cis-bis(isothiocyanato)bis(2,2'-bipyridyl-4,4'-dicarboxylato)-ruthenium ('N3 dye'), represented by Formula 3 below, for 24 hours and then dried, thereby adsorbing the dye on the surface of the $TiO_2$ layer. After the completion of the adsorption of the dye, ethanol was sprayed on the layer, to wash the unadsorbed dye off of the light-absorbing layer, and then dried.

Thereafter, 13.8 mg of 4-hydroxybenzoic acid (0.1 mmol) was added to 50 ml of a hexane solvent, and the resulting solution was ultrasonicated at 50°C for 10 minutes using a sonicator in a sealed state. Then, the above film having the dye adsorbed thereon was immersed in the ultrasonicated solution, allowed to stand in a sealed state for 24 hours in a darkroom so as to adsorb the 4-hydroxybenzoic acid, was sufficiently washed with hexane at 50°C, and then dried, thus fabricating a semiconductor electrode.

Formula 3

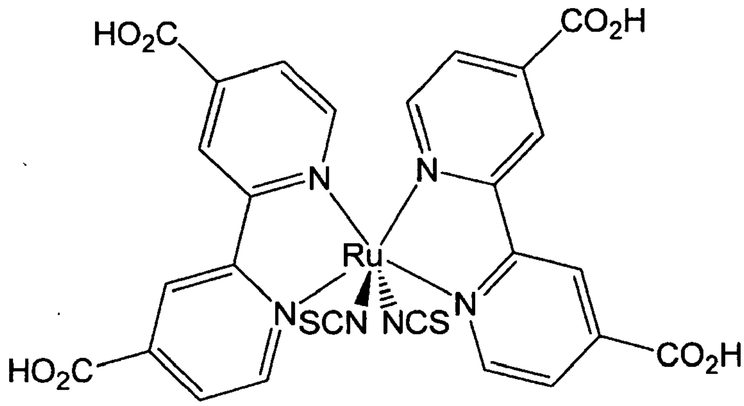

Example 2

A semiconductor electrode was fabricated in the same manner as in Example 1, with the exception that 4-ethoxysalicylic acid (0.1 mmol, 18.2 mg) was used instead of 4-hydroxybenzoic acid.

Example 3

A semiconductor electrode was fabricated in the same manner as in Example 1, with the exception that 5-(4-methoxyphenyl)1,3,4-oxydazole-2-thiol (0.1 mmol, 20.8 mg) was used instead of 4-hydroxybenzoic acid.

Example 4

A semiconductor electrode was fabricated in the same manner as in Example 1, with the exception that 4-(octyloxy)benzoic acid (0.1 mmol, 25.0 mg) was used instead of 4-hydroxybenzoic acid.

Experimental Example 1

The semiconductor electrode obtained in Example 1 was washed with ethanol and then dried at 80°C, and the FTIR spectrum thereof was measured. For this, the FTIR spectrum was measured using an FTS 7000 FTIR spectrometer (commercially available from Digilab, USA). The spectrum of the semiconductor electrode obtained in Example 1 is shown along with the FTIR spectra of the dye and organic material in FIG. 4.

As shown in FIG. 4, the dye (N3) adsorbed on the surface of $TiO_2$ was not structurally changed even after having been treated using the organic material having an electron-donating group. In addition, the SCN functional group of the N3 dye was not affected by the treatment using the organic material having an electron-donating group.

Examples 5 to 8

The surface of a conductive transparent glass substrate coated with ITO was coated with platinum, thus manufacturing a counter electrode. Then, the counter electrode, serving as an anode, was assembled with each of the semiconductor electrodes, serving as a cathode, obtained in Examples 1 to 4. When the anode and cathode were assembled, the conductive surfaces thereof were disposed to face the inner portion of the cell, thus forming a platinum layer and light-absorbing layer opposite each other. In this case, a SURLYN film (e.g., DuPont, 100 $\mu$m) was interposed between the two electrodes, and the two electrodes were compressed under about 2 atm on a heating plate at a temperature of about 120°C.

Subsequently, the space between the two electrodes was filled with the electrolytic solution, thus completing the dye-sensitized solar cell of the present invention. As such, the electrolytic solution was $I_3^-/I^-$ electrolytic solution obtained by dissolving 0.6 M 1,2-dimethyl-3-octyl-imidazolium iodide, 0.2 M LiI, 0.04 M $I_2$, and 0.2 M 4-tert-butyl-pyridine (TBP) in acetonitrile.

Comparative Example 1

A solar cell was fabricated in the same manner as in Example 5, with the exception that the surface of the semiconductor electrode was not treated with the organic material having an electron-donating group.

Examples 9~11

Solar cells were fabricated in the same manner as in Example 5, with the exception that the semiconductor electrode having the dye adsorbed thereon was treated using a solution of 2 mM 4-ethoxysalicylic acid dissolved in each of 50 ml of toluene, methylene chloride, and hexane in order to evaluate the effect of the solvent upon treatment using the organic material having an electron-donating group. Then, the variation in photoelectric efficiency of each of the solar cells with the type of solvent was measured. The results are given in Table 2 below.

Examples 12~14

Solar cells were fabricated in the same manner as in Examples 9~11, with the exception that 4-hydroxybenzoic acid was used instead of 4-ethoxysalicylic acid. Then, the variation in photoelectric efficiency of each of the solar cells with the type of solvent was measured. The results are given in Table 2 below.

Experimental Example 2

The photovoltage and photocurrent of each of the photoelectric conversion devices fabricated in Examples 5~8 and Comparative Example 1 were measured, and then the photoelectric efficiency was calculated. As such, as a light source, a Xenon lamp (e.g., Oriel, 01193) was used, and the radiation conditions (AM 1.5) of the Xenon lamp were corrected using a standard solar cell (e.g., Furnhofer Institute Solare Engeriessysteme, Certificate No. C-ISE369, Type of material: Mono-$Si^+$ KG filter). The short-circuit photocurrent density ($I_{sc}$), open-circuit voltage ($V_{oc}$) and fill factor (FF) calculated from the measured photocurrent-voltage curve were substituted into Equation 1 below, thus calculating the photoelectric efficiency ($\eta_e$). The results are given in Table 1 below.

Equation 1

$$\eta_e = (V_{oc} \times I_{sc} \times FF) / (P_{inc})$$

wherein $P_{inc}$ shows $100 mW/cm^2$(1sun).

TABLE 1

| | $I_{sc}$ (mA) | $V_{oc}$ (mV) | FF | Photoelectric Efficiency (%) |
|---|---|---|---|---|
| Ex. 5 | 7.338 | 774 | 0.687 | 3.793 |
| Ex. 6 | 8.966 | 744 | 0.621 | 4.037 |
| Ex. 7 | 7.151 | 740 | 0.626 | 3.223 |
| Ex. 8 | 7.601 | 770 | 0.632 | 3.622 |
| C.Ex. 1 | 6.033 | 723 | 0.639 | 2.713 |

As is apparent from Table 1, in the solar cell comprising the semiconductor electrode of the present invention, the short-circuit photocurrent density ($I_{sc}$) increased by blocking back electron transfer in the semiconductor electrode and the open-circuit voltage ($V_{oc}$) also increased through the electron donating effect of the organic material. Thus, the solar cell of the present invention was confirmed to have increased photoelectric efficiency.

Experimental Example 3

The photovoltage and photocurrent of each of the photoelectric conversion devices fabricated in Examples 9-14 and Comparative Example 1 were measured, and thus the photoelectric efficiency was calculated. The results are

given in Table 2 below.

TABLE 2

| | $I_{sc}$ (mA) | $V_{oc}$ (mV) | FF | Photoelectric Efficiency (%) | Photoelectric Efficiency Increase (%) |
|---|---|---|---|---|---|
| Ex. 9 | 8,785 | 767 | 0.655 | 4.294 | 58 |
| Ex. 10 | 7.233 | 732 | 0.583 | 3.002 | 10 |
| Ex. 11 | 8.966 | 744 | 0.621 | 4.037 | 48 |
| Ex. 12 | 8.766 | 768 | 0.664 | 4.349 | 60 |
| Ex. 13 | 8.107 | 752 | 0.665 | 3.942 | 45 |
| Ex. 14 | 7.338 | 774 | 0.687 | 3.793 | 39 |
| C. Ex. 1 | 6.033 | 723 | 0.639 | 2.713 | - |

As is apparent from Table 2, when the solvent was toluene, the photoelectric efficiencies of the solar cells of Example 9 and Example 12 were increased to 58% and 60%, respectively, compared to that of the solar cell of Comparative Example 1, which was not treated using the organic material. Thereby, the solvent used for the treatment with the organic material having an electron-donating group was confirmed to affect the photoelectric efficiency. Further, of the solvents used, toluene could be seen to exhibit an effect that was superior to hexane or methylene chloride.

As previously described herein, the present invention provides a semiconductor electrode, a fabrication method thereof, and a solar cell comprising the same. The surface of the semiconductor electrode of the present invention is treated with an aromatic or heteroaromatic organic material having an electron-donating group, and thus, back electron transfer is prevented in the semiconductor electrode and the electrons are transferred to the metal oxide layer, therefore increasing both short-circuit photocurrent density ($I_{sc}$) and open-circuit voltage ($V_{oc}$) , resulting in increased photoelectric efficiency. Hence, the use of the semiconductor electrode of the present invention results in the fabrication of a solar cell having high efficiency.

## Claims

1. A semiconductor electrode comprising a metal oxide layer of metal oxide nanoparticles having dye molecules adsorbed thereon, in which a surface of the metal oxide layer is treated with an aromatic or heteroaromatic organic material having an electron-donating group.

2. The semiconductor electrode as claimed in claim 1, wherein the organic material has a structure represented by Formula 1 or Formula 2 below:

Formula 1

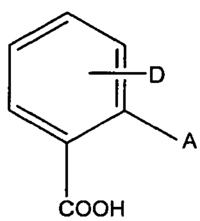

wherein A is H, COOH, OH, OR or SH, and D is H, OH, R, OR, SH, NRR' or halogen elements, in which R and R' are each a $C_1$~$C_{10}$ alkyl group;

Formula 2

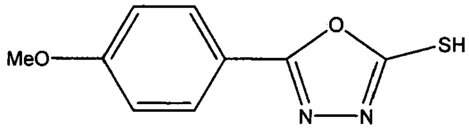

3. The semiconductor electrode as claimed in claim 2, wherein the organic material is selected from benzoic acid, salicylic acid, 4-octylbenzoic acid, 4-(octyloxy)benzoic acid, 4-ethoxysalicylic acid and 5-(4-methoxyphenyl)1,3-oxadiazole-2-thiol.

4. The semiconductor electrode as claimed in any of claims 1 to 3, wherein the metal oxide comprises at least one selected from titanium oxide, niobium oxide, hafnium oxide, indium oxide, tin oxide and zinc oxide.

5. The semiconductor electrode as claimed in any of claims 1 to 4, wherein the metal oxide is a nanomaterial comprising quantum dots, nanodots, nanotubes, nanowires, nanobelts or nanoparticles.

6. A method of fabricating a semiconductor electrode, the method comprising:

forming a metal oxide layer on a transparent electrode, the metal oxide layer having a dye adsorbed; and treating a surface of the metal oxide layer with an aromatic or heteroaromatic organic material having an electron-donating group.

7. The method as claimed in claim 6, wherein the organic material has a structure represented by Formula 1 or Formula 2 below:

Formula 1

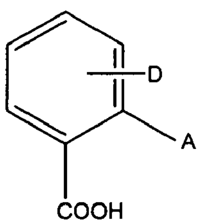

wherein A is H, COOH, OH, OR, or SH, and D is H, OH, R, OR, SH, NRR', or halogen elements, in which R and R' are each a $C_1$~$C_{10}$ alkyl group;

Formula 2

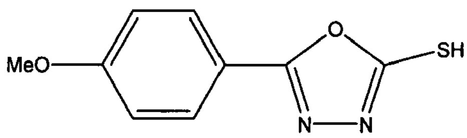

8. The method as claimed in claim 6 or 7, wherein the treating a surface of the metal oxide layer is conducted by immersing the semiconductor electrode having a light-absorbing layer in a dispersion of the aromatic or heteroaromatic organic material having an electron-donating group in a solvent.

9. The method as claimed in claim 6 or 7, wherein the treating a surface of the metal oxide layer is conducted by spraying a dispersion of the aromatic or heteroaromatic organic material having an electron-donating group in a solvent onto the semiconductor electrode having a light-absorbing layer.

**10.** The method as claimed in claim 8 or 9, wherein the solvent comprises at least one selected from pentane, hexane, benzene, toluene, xylene, dichloromethane and chloroform.

**11.** The method as claimed in any of claims 8 to 10,
wherein the dispersion of the organic material in the solvent is prepared via ultrasonic treatment or heat treatment.

**12.** The method as claimed in any of claims 8 to 11, further comprising washing a substrate comprising the organic material with the solvent.

**13.** A solar cell comprising:

a semiconductor electrode;
a counter electrode; and
an electrolyte intermediate the semiconductor electrode and the counter electrode,
wherein the semiconductor electrode is as claimed in any of claims 1 to 5.

Fig. 1

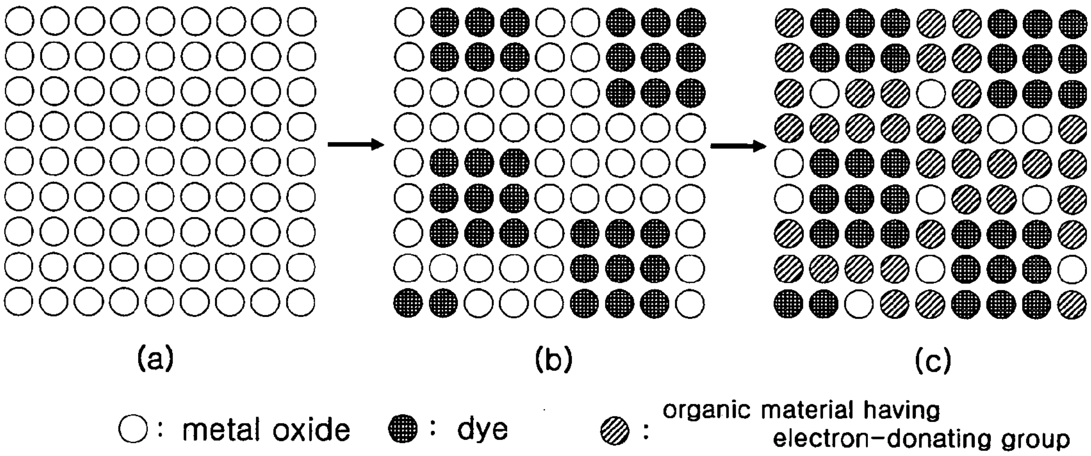
(a)
(b)
(c)
: metal oxide
: dye
: organic material having electron-donating group

Fig. 2

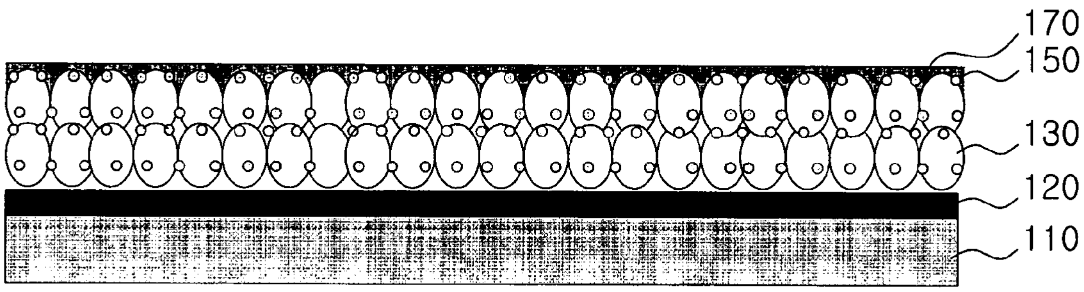
170
150
130
120
110

**Fig. 3**

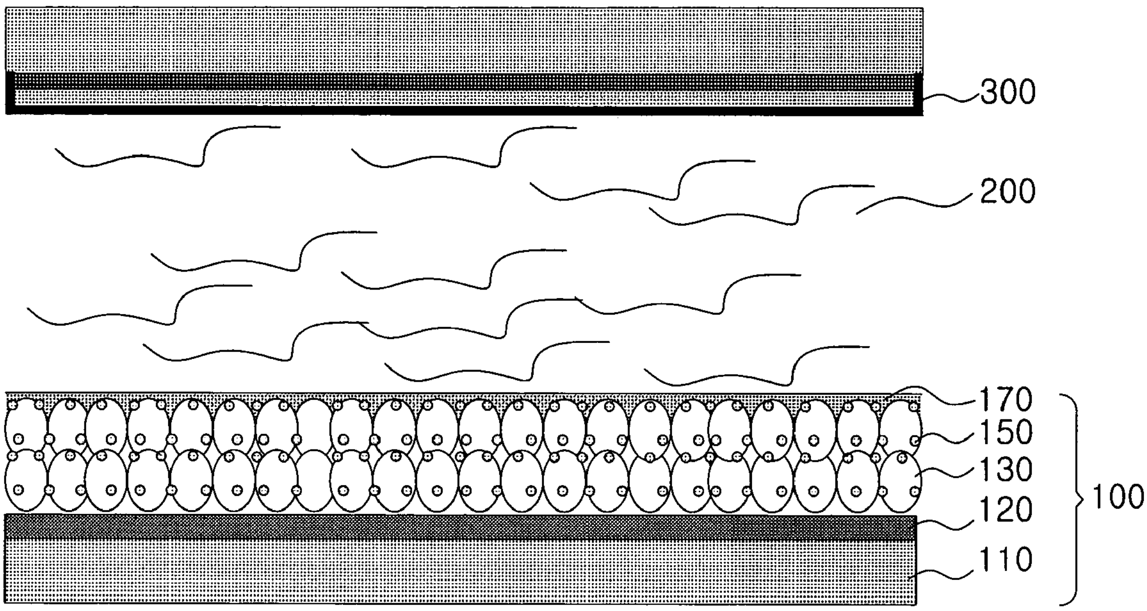

Fig. 4

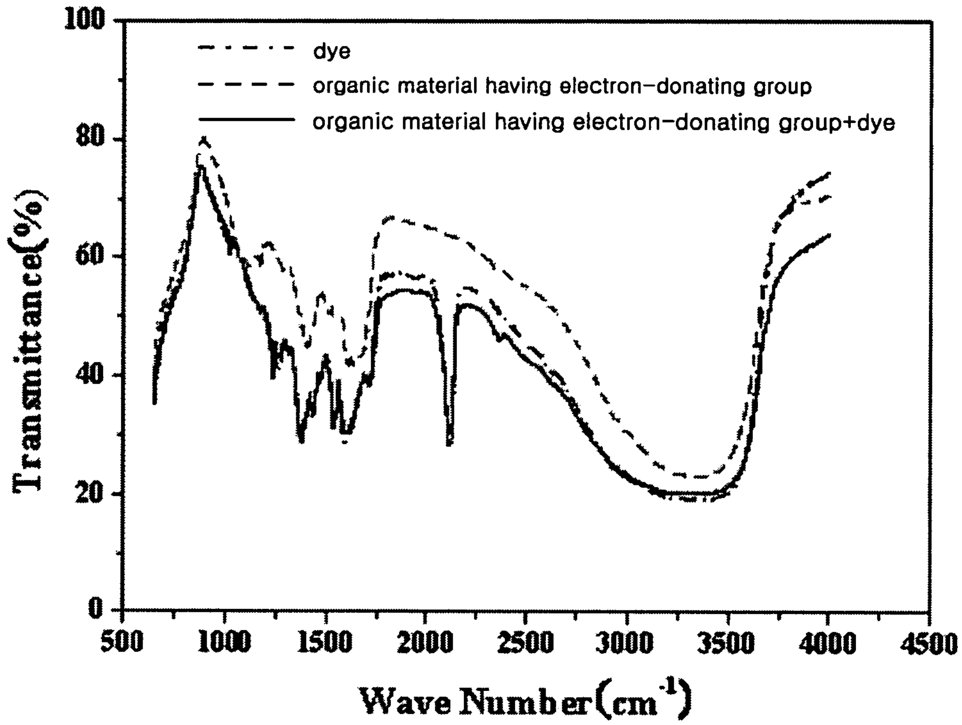
dye
organic material having electron-donating group
organic material having electron-donating group+dye
Transmittance(%)
0
20
40
60
80
100
500
1000
1500
2000
2500
3000
3500
4000
4500
Wave Number($cm^{-1}$)

European Patent Office

# EUROPEAN SEARCH REPORT

Application Number
EP 06 25 4369

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2004/090921 A2 (IMP COLLEGE INNOVATIONS LTD [GB]; UNIV CAMBRIDGE TECH [GB]; DURRANT JA) 21 October 2004 (2004-10-21)<br>* see p.3, l.16 - p.7, l.26, claims *<br>* the whole document *<br>----- | 1-13 | INV.<br>H01M14/00<br><br>ADD.<br>H01L31/04<br>H01L31/042 |
| D,X | JP 2004 171969 A (AMAO YUTAKA)<br>17 June 2004 (2004-06-17)<br>* abstract *<br>----- | 1-13 | |
| Y | KRUEGER J ET AL: "MODIFICATION OF TIO2 HETEROJUNCTIONS WITH BENZOIC ACID DERIVATIVES IN HYBRID MOLECULAR SOLID-STATE DEVICES"<br>ADVANCED MATERIALS, WILEY VCH, WEINHEIM, DE,<br>vol. 12, no. 6,<br>16 March 2000 (2000-03-16), pages 447-451, XP000923878<br>ISSN: 0935-9648<br>* see p.449, Fig.2 *<br>* the whole document *<br>----- | 1-13 | TECHNICAL FIELDS SEARCHED (IPC)<br>H01M |
| Y | JP 2002 324589 A (FUJI PHOTO FILM CO LTD)<br>8 November 2002 (2002-11-08)<br>* abstract *<br>----- | 1-13 | |
| Y | EP 1 311 001 A (NIPPON KAYAKU KK [JP])<br>14 May 2003 (2003-05-14)<br>* see p.8 - 20, formula, claims *<br>* the whole document *<br>----- | 1-13 | |
| Y | US 6 359 211 B1 (SPITLER MARK T [US] ET AL) 19 March 2002 (2002-03-19)<br>* see col.5-7, claims "<br>* the whole document *<br>-----<br>-/-- | 1-13 | |

The present search report has been drawn up for all claims

| Place of search | Date of completion of the search | Examiner |
|---|---|---|
| Munich | 25 October 2006 | Stellmach, Joachim |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

2

EPO FORM 1503 03.82 (P04C01)

European Patent Office

# EUROPEAN SEARCH REPORT

Application Number
EP 06 25 4369

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | JP 2004 014175 A (NIPPON KAYAKU KK) 15 January 2004 (2004-01-15) * abstract * ----- | 1-13 | |
| Y | JP 2005 135656 A (YANAGIDA SHOZO; NIPPON KAYAKU KK) 26 May 2005 (2005-05-26) * abstract * ----- | 1-13 | |
| | | | TECHNICAL FIELDS SEARCHED (IPC) |

The present search report has been drawn up for all claims

| Place of search | Date of completion of the search | Examiner |
|---|---|---|
| Munich | 25 October 2006 | Stellmach, Joachim |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

2

EPO FORM 1503 03.82 (P04C01)

## ANNEX TO THE EUROPEAN SEARCH REPORT ON EUROPEAN PATENT APPLICATION NO. EP 06 25 4369

This annex lists the patent family members relating to the patent documents cited in the above-mentioned European search report.
The members are as contained in the European Patent Office EDP file on
The European Patent Office is in no way liable for these particulars which are merely given for the purpose of information.

25-10-2006

| Patent document cited in search report | Publication date | Patent family member(s) | Publication date |
|---|---|---|---|
| WO 2004090921 A2 | 21-10-2004 | EP 1629511 A2 | 01-03-2006 |
| JP 2004171969 A | 17-06-2004 | NONE | |
| JP 2002324589 A | 08-11-2002 | NONE | |
| EP 1311001 A | 14-05-2003 | CA 2417502 A1 | 27-01-2003 |
| | | CN 1441969 A | 10-09-2003 |
| | | WO 0211213 A1 | 07-02-2002 |
| | | TW 595034 B | 21-06-2004 |
| | | US 2003152827 A1 | 14-08-2003 |
| US 6359211 B1 | 19-03-2002 | NONE | |
| JP 2004014175 A | 15-01-2004 | NONE | |
| JP 2005135656 A | 26-05-2005 | NONE | |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2004171969 A